Europäisches Patentamt

European Patent Office

Office européen des brevets

(19)

(11) Publication number: **0 084 424**

A2

# (12) EUROPEAN PATENT APPLICATION

(21) Application number: 83300119.1

(22) Date of filing: 07.01.83

(51) Int. Cl.³: **H 01 L 21/56**
**H 01 L 21/48**

(30) Priority: 07.01.82 US 337896
22.12.82 US 451308

(43) Date of publication of application:
27.07.83 Bulletin 83/30

(84) Designated Contracting States:
DE FR GB IT NL SE

(71) Applicant: AMERICAN MICROSYSTEMS,
INCORPORATED
3800 Homestead Road
Santa Clara, CA 95051(US)

(72) Inventor: Lee, Jong-Sang
1055-69, N. Capitol
San Jose California 95132(US)

(74) Representative: Howden, Christopher Andrew et al,
FORRESTER & BOEHMERT Widenmayerstrasse 4/1
D-8000 München 22(DE)

(54) Chemical removal of resin bleed from encapsulated devices and device treated by the method.

(57) In a method for the chemical removal of resin bleed from synthetic resin-encapsulated semiconductor devices, moulded parts are first deflashed, simultaneously removing encapsulating material from between adjacent leads and removing those portions of the lead frame which hold the leads fixed during the moulding operation. The lead frame is then cleaned, and subjected to chemical treatment by applying to the device a material which is a solvent of the encapsulating resin for a time sufficient to remove the resin bleed but insufficient to cause appreciable damage to the resin encapsulation. After removal of the resin bleed the device is rinsed and the lead frame is plated or solder-dipped in known fashion.

FIG. 2

0084424

Chemical removal of resin bleed from encapsulated devices and device treated by the method

THIS INVENTION relates to semiconductor fabrication, and more specifically to the packaging of semiconductor devicess in moulded plastics packages.

The use of a moulded plastic package to encapsulate a semiconductor device which has been mounted on a lead frame, providing leads which extend from the plastic package, is well known in the prior art. Plastic material used for forming such a moulded package typically comprises epoxy silicone or epoxy novalac, for example any of the following materials, namely the material designated Dow Corning 631, available from Dow Corning, the materials designated Plaskon 3200LS and Plaskon 292B available from Plaskon Corporation of Toledo, Ohio, the materials designated Hysol MH 19F-0294 and Hysol MH 20F available from Hysol Corporation, Olean, New York, or the materials designated Morton 410B and Morton 421, available from Morton Corporation of Woodstock, Illinois. Other plastics materials may, of course, be used. Epoxy silicone is described, for example, in United States Patent No. 4,202,811. During the moulding or encapsulation process, the lead frame is placed in the lower half of a two-piece mould. The upper half of the mould is then brought into contact with the lower half, so that the lead frame is located between the two halves of the mould with the leads extending out of the mould cavity. Those portions of the lead frame which are to be encapsulated are located within the mould during the encapsulation process. However, it is not practicable to make the two halves of the mould a perfect fit, particularly with respect to the leads, and a small amount of the encapsulating material flows out from the region to be encapsulated onto the leads 15 during moulding. This small amount of encapsulating material, often called "resin bleed", typically comprises the same material as that used to encapsulate the semiconductor die.

This resin bleed, if not removed, will prevent the plating of those portions of the leads covered by the resin bleed. Unplated portions of the leads are subject to corrosion during the operating life of the device. Furthermore, with severe cases of resin bleed, the resin bleed extends onto those portions of the leads which are to be soldered or plugged into electrical sockets, thus preventing reliable low-resistance connections to other components.

Prior to the discovery of the method for removing resin bleed in accordance with this invention, resin bleed was typically removed soon after moulding by mechanical scraping action by the operator of the moulding equipment, or by additional personnel. This scraping operation, in addition to requiring additional manpower, thus increasing encapsulation costs, often resulted in incomplete removal of the resin bleed and physical damage of the encapsulated device. For example, it was common for leads to be broken, or severely gouged, thus weakening the leads and producing package failures.

It is an object of the present invention, in one of its aspects, to provide an improved method for the removal of resin bleed from an encapsulated semi-conductor device.

According to this aspect of the invention, there is provided a method for the chemical removal of resin bleed from an encapsulated semiconductor device characterized by the step of applying to said encapsulated device a material which is a solvent of the resin for a time sufficient to remove said resin bleed, but for a time insufficient to cause appreciable damage to the device encapsulation.

Embodiments of the invention are described below by way of example, with reference to the accompanying drawings in which:

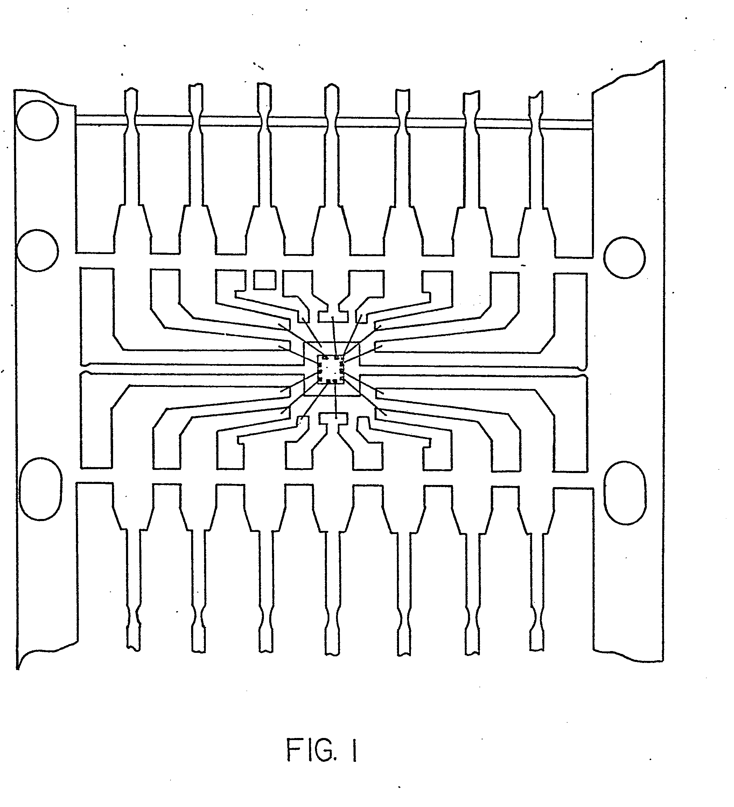

FIGURE 1 is a top view of a semiconductor device and lead frame prior to encapsulation showing a semiconductor die mouted on the lead frame and bonding wires fixed between the semiconductor die and the leads of the lead frame;

FIGURE 2 shows the semiconductor device after it has been encapsulated in synthetic resin;

FIGURE 3 is a top view of the encapsulated device after removal of the resin bleed by a method embodying the invention; and

FIGURE 4 is a perspective view of a finished encapsulated semiconductor device.

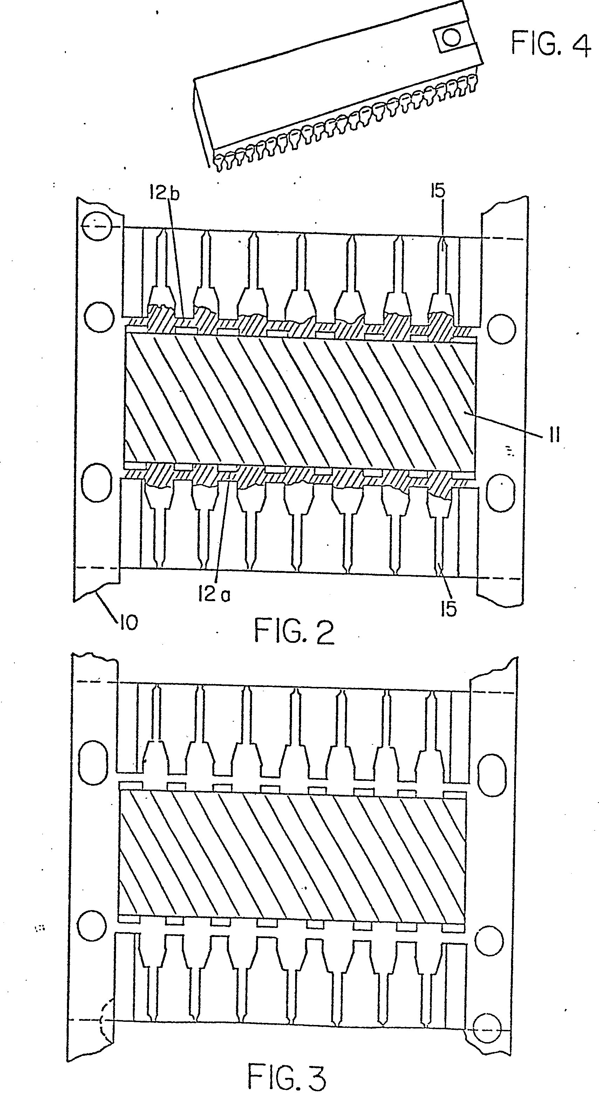

Referring to the drawings, after a semiconductor die has been attached to a lead frame and bonding wires fixed between the semiconductor device and the leads of the lead frame, the device is encapsulated in synthetic resin, by moulding, as described above. Figure 2 shows the device, including the peripheral portion of the lead frame, referenced 10, after the semiconductor die and the central portion of the lead frame have been encapsulated in a body 11 of synthetic resin. Resin bleed, indicated at 12a, 12b, is shown as extending from the body 11 over the lead 15. The moulded parts of the package are first deflashed, the encapsulating material being removed from between adjacent leads at the same time as those portions of the lead frame holding the leads fixed during the moulding operation are removed. The encapsulated device is next cleaned, for example, by dipping in a 50% sulfuric acid solution at approximately $85^{\circ}C$, followed by a rinse in de-ionized water. This cleaning step serves to slightly etch the lead frame material under the resin bleed which aids in the removal of the resin bleed. However, this cleaning step is not essential to the removal of resin bleed in accordance with this invention.

The resin bleed 12a, 12b of Figure 2 is then removed by applying to the encapsulated device a chemical which is capable of acting as a solvent with respect to the resin bleed material. Such a solvent may comprise, for example, a haloginated hydrocarbon, an organic acid and a haloginated hydrocarbon, an inorganic acid and a haloginated hydrocarbon, or a base and a haloginated hydrocarbon. Such haloginated hydrocarbons include chlorinated hydrocarbons, such as methylene chloride, for example. Other compounds can be used in place of methylene chloride, such as cyclic amides (for example, N-methyl-2-pyrrolidene) and oxyginated sulfers (for example, dimethyl sulfoxide). Organic acids which are suitable include formic acid, phenol (carbolic acid), and carboxylic acids, such as acetic acid, for example. One such commercially available solvent is Dynasolve 160, manufactured and sold by Dynaloy, Inc. of Hanover, New Jersey. Dynasolve comprises a mixture of methylene chloride, phenol, acetic acid, and formic acid. Prior to the discovery that such solvents can be utilized to remove resin bleed after encapsulation, such solvents were used for the removal of substantially all of the encapsulating material surrounding the semi-conductor die for the purpose of detailed visual, electrical and mechanical analysis of the semiconductor die and bonding wires connected between the semiconductor die and the lead frame.

In order to assist in removal of resin bleed, the encapsulated device is preferably submerged in the solvent, for example in a tank, and ultrasonic energy applied to the solvent to agitate it during the time that the device is submerged. Alternatively, other means for agitating the solvent is used.

When Dynasolve 160 is utilized as a solvent for the removal of resin bleed, Dynasolve 160 may be utilized at either room temperature or higher temperatures, up to the boiling point of Dynasolve 160 (approximately 40$^{\circ}$C), and in general at a temperature between 20$^{\circ}$C and 40$^{\circ}$C. When devices are submerged in Dynasolve 160 at room temperature which is agitated by ultrasonic energy, approximately 15 to 20 minutes is required to remove all traces of resin bleed. Similarly, when devices are submerged in Dynasolve 160 which is heated to approximately 35$^{\circ}$C and agitated by ultrasonic energy, approximately 15 minutes is required to remove all traces of resin bleed.

If desired, in order to minimize the evaporation of the solvent, an evaporation seal is formed on top of the solvent in the tank. For example, water, or other suitable liquids or materials, can be used to form an evaporation seal on the surface to a thickness, for example, within the range of approximately 3/4 to 1 inch, although this thickness is not critical. This is easily done, because the density of water is sufficiently less than the density of the solvent to allow the formation of the water seal, even when ultrasonic energy or other means are used to agitate the solvent. Evaporation of the solvent is further minimized by utilizing a cooling coil of well known design near the top of the tank containing the solvent, thereby causing the condensation of substantially all vaporized solvent.

Additional commercially available solvents suitable for use in carrying out the method of this invention are Uresolve-R and Uresolve-S.G., also manufactured by Dynaloy, Inc. Uresolve-R and Uresolve-S.G. are typically utilized at room temperature for approximately 30 minutes in order to remove all traces of resin bleed. Of importance, if Uresolve-R or Uresolve-S.G. are heated to a temperature in excess of approximately $90^{0}C \pm 5^{0}C$, undesirable discolouration of the package body will result, although the colour of the package body is not critical to the mechanical or electrical quality or reliability of an encapsulated semiconductor device.

The above times and temperatures are based upon the application of ultrasonic energy to the solvent (i.e. approximately 400-1300 watts at approximately 25 KHz applied to a 10 to 15 U.S. gallon (37850 to 56775 CC) volume of solvent) during the removal of resin bleed from an encapsulated device in accordance with the teachings of this invention. The application of ultrasonic energy is accomplished, for example, by utilizing the Branson model EML 70-36 ultrasonic generator available from Branson Cleaning Equipment Company of Shelton, Connecticut.

The size of the devices being cleaned is inversely proportional to the number of devices which can be completely by cleaned of all resin bleed in a single cleaning cycle. For example, utilizing a 15 U.S. gallon volume of Dynasolve 160 with a water seal and cooling coils, as previously described, and approximately 1260 watts of 25 KHz ultrasonic energy, thereby removing all traces of resin bleed, following cycle times and quantities are achieved:

| Device Size (Number of Leads) | Number of Devices per Cleaning Cycle | Minutes per Cleaning Cycle | Number of Devices Cleaned per Gallon of Solvent Consumed |
|---|---|---|---|
| 8 | 6600 | 15-20 Minutes | 45,000 |
| 14 | 6600 | 15-20 Minutes | 26,000 |
| 16 | 6600 | 15-20 Minutes | 23,000 |
| 22 | 6600 | 15-20 Minutes | 16,000 |
| 24 | 4200 | 15-20 Minutes | 15,000 |
| 28 | 4200 | 15-20 Minutes | 13,000 |
| 40 | 2000 | 15-20 Minutes | 9,000 |
| 64 | 900 | 15-20 Minutes | 5,600 |

After removal of the resin bleed from the device, the device is rinsed. With the resin bleed removed, the lead frame is plated or solder-dipped in known fashion.

Thus, by the above described methods embodying this invention, resin bleed is removed from plastic encapsulated semiconductor devices without the need for mechanical abrasion of the leads, thus increasing yield and minimizing potential damage to the devices. Furthermore, it will be apparent to those of ordinary skill in the art in the light of teachings of this specification that the disclosed method for removing chemically resin bleed from semi-conductor devices is also suitable for use with articles other than semiconductor devices, such as for removing resin from moulds, mould plates, or removing resin bleed from objects other than semiconductor packages.

The specific embodiments of this invention described in this specification are intended to serve by way of example and are not a limitation on the scope of the invention. Numerous other embodiments of this invention, within the scope of the accompanying claims, will become apparent to those of ordinary skill in the art in light of the teachings of this specification.

CLAIMS:

1. A method for the chemical removal of resin bleed from an encapsulated semiconductor device characterized by the step of applying to said encapsulated device a material which is a solvent of the resin for a time sufficient to remove said resin bleed, but for a time insufficient to cause appreciable damage to the device encapsulation.

2. A method as claimed in claim 1 characterized in that said encapsulated device is submerged in said solvent.

3. A method as claimed in claim 1 or claim 2 characterized in that said solvent is agitated during the time said device is submerged in said solvent.

4. A method as claimed in claim 3 characterized in that said agitation is provided by an ultrasonic energy source.

5. A method as claimed in any preceding claim characterized in that said solvent comprises a haloginated hydrocarbon.

6. A method as claimed in claim 5 characterized in that said haloginated hydrocarbon comprises methylene chloride.

7. A method as claimed in any preceding claim characterized in that said solvent acid comprises acetic acid.

8. A method as claimed in any preceding claim characterized in that said solvent is contained within a tank and said solvent is sealed by a layer of material formed on its surface.

9. A method as claimed in claim 8 characterized in that said layer of material formed on the surface of the solvent is a layer of water which is within the range of approximately 3/4 to 1 inch in thickness.

10. An encapsulated semiconductor device which has been treated by the method of any preceding claim.

11. A method for the chemical removal of resin bleed from a device incorporating a resin characterized by the step of applying to said device a material which is a solvent of said resin for a time sufficient to remove said resin bleed, but for a time insufficient to cause appreciable damage to said device.

FIG. 1

FIG. 4

12 b                    15

11

12 a

10

FIG. 2

15

FIG. 3